# EUROPÄISCHE PATENTSCHRIFT

(11) **EP 1 415 015 B1**
(45) Veröffentlichungstag und Bekanntmachung des Hinweises auf die Patenterteilung: **27.10.2010**
(21) Anmeldenummer: 02754984.9
(22) Anmeldetag: 07.08.2002
(51) Int. Cl.: C23C 16/04, C23C 16/511, C23C 16/515, B29C 49/42, H01J 37/32

(54) **VERFAHREN UND VORRICHTUNG ZUM BESCHICHTEN UND BLASFORMEN EINES KÖRPERS**
METHOD AND DEVICE FOR THE COATING AND BLOW MOULDING OF A BODY
PROCEDE ET DISPOSITIF POUR ENDUIRE ET SOUFFLER UN CORPS SUR MATRICE

(30) Priorität: 07.08.2001 DE 10138697
(43) Veröffentlichungstag der Anmeldung: 06.05.2004
(73) Patentinhaber: Schott AG, 55122 Mainz (DE)
(72) Erfinder: BEHLE, Stephan, 55278 Hahnheim (DE); BICKER, Matthias, 55126 Mainz (DE)
(74) Vertreter: Herden, Andreas F.
(86) Internationale Anmeldenummer: PCT/EP2002/008850
(87) Internationale Veröffentlichungsnummer: WO 2003/014412

(56) Entgegenhaltungen:
- WO-A-01/46990
- WO-A-99/17334
- DE-C- 4 034 211
- FR-A- 2 792 854
- US-B1- 6 200 651

## Beschreibung

Die Erfindung betrifft ein Verfahren sowie eine Vorrichtung zum Beschichten und Blasformen eines Körpers gemäß Anspruch 1 bzw. Anspruch 8.

Um im Bereich von Kunststoffverpackungen für eine Reduktion der Permeation von Gasen und Flüssigkeiten zu sorgen sowie das Kunststoffmaterial gegen chemische Angriffe oder UV-Strahlung zu schützen, ist es vorteilhaft, Substratmaterialien, insbesondere e Hohlkörper, mit einer Beschichtung insbesondere Barrierebeschichtung zu versehen.
Durch Beschichtungen können mit kostengünstigen Massenkunststoffen dieselben Eigenschaft wie bei teuren Spezialkunststoffen erreicht und der Ersatz von beispielsweise Glas im Bereich der Pharmaverpackungen wird durch derartige Massenkunststoffe ermöglicht. Das Aufbringen von Beschichtungen auf ein Kunststoffsubstrat ist aus nachfolgenden Anmeldungen bekanntgeworden:
US 5,798,139
US 5,833,752
US 6,001,429
WO 99/17334
WO 00/66804

Die US 5,798,139 beschreibt die Herstellung von Plastikbehältern mit einer Kohlenstoffilmbeschichtung. Der Kohlenstoffilm soll eine Gasbarriere darstellen und das Problem der Sorption aus dem Kunststoffmaterial lösen.

Aus der US 5,833,752 ist ein System bekanntgeworden, bei dem die Barrierebeschichtung aus einem Plasma aufgebracht wird. Die Energie zur Aufrechterhaltung des Plasmas wird durch Einrichtungen aufgebracht, die sich dadurch auszeichnen, daß die Energie in das Innere der zu beschichtenden Behältern über eine Außenelektrode eingebracht wird.

Aus der US 6,001,429 ist wiederum das Aufbringen einer Sperrschicht auf die Innenfläche eines Kunststoffsubstrates bekanntgeworden, wobei HMDSO als Monomer-Gas zusammen mit einem Sauerstoffträger-Gas in das Innere des zu beschichtenden Artikels geleitet wird.

Aus der WO 99/17334 ist ein Verfahren zur Innen- bzw. Außenbeschichtung bekanntgeworden, bei dem eine Beschichtungsvorrichtung zur Beschichtung eines Kunststoffbehälters mit einer Streckblasvorrichtung kombiniert wurde. Zur Anregung des Plasmas wird Mikrowellenenergie kontinuierlich so eingestrahlt, daß im Innern des zu beschichtenden Körpers bzw. der Vakuumkammer eine TM-Mode angeregt wird, bei der das Magnetfeld keine axiale Komponenten besitzt. Nachteilig an der aus der WO 99/17334 bekannten Vorrichtung ist, daß bei kontinuierlicher Mikrowelleneinstrahlung die Kontrolle der Schichtdicke nur eingeschränkt möglich ist. Ein weiterer Nachteil ist, daß die Anregung einer TM-Mode bestimmte geometrische Abmessungen voraussetzt, so daß die Beschichtung beliebiger Körper nicht möglich ist.

Aus der WO 00/66804 ist eine Beschichtungsvorrichtung zur Beschichtung eines Körpers mit Hilfe eines Mikrowellenplasmas bekanntgeworden, bei dem die Mikrowellenstrahlung über einen Hohlleiter im wesentlichen senkrecht zur Symmetrieachse des zu beschichtenden Behälters eingekoppelt wird.

Aufgabe der Erfindung ist es, ein Verfahren und eine Vorrichtung anzugeben, mit dem Körper beliebiger Größe und Geometrie durch Blasformen, wie insbesondere durch Spritzblasen hergestellt und beschichtet werden können.

Erfindungsgemäß wird die Aufgabe durch ein Verfahren zum Blasformen, insbesondere Spritzblasen und Beschichten eines Körpers gelöst, bei dem zunächst in einem Beschichtungsreaktor mit.wenigstens einer Öffnung durch diese Öffnung Kunststoffmaterial eingebracht wird, durch Einblasen eines Gases durch diese Öffnung ein Körper geformt wird, der anschließend alleine oder zusammen mit dem ihn umgebenden Beschichtungsreaktor evakuiert wird. In dem Körper und/oder dem Beschichtungsreaktor wird ein Precursor-Gas in das Gas einer Gasatmosphäre eingeleitet. Daran anschließend wird im Inneren des Körpers und/oder dem umgebenden Beschichtungsreaktor gepulste Mikrowellenenergie eingekoppelt, so daß sich eine Beschichtung auf der Innen- und Außenseite des Körpers abscheidet.

Der Vorteil im Eintragen von gepulster Mikrowellenenergie anstatt kontinuierlicher Mikrowellenenergie wie im Stand der Technik liegt darin, daß es mit Hilfe der gepulsten Mikrowellenenergie möglich ist, stabil TEM-Moden, TE-Moden oder aber die TM010-Mode im Reaktor anzuregen. Daher werden in einer ersten Ausführungsform der Erfindung durch die gepulste Mikrowellenenergie im Innern des Körpers und/oder dem Beschichtungsreaktor TE-Moden oder TEM-Moden angeregt. Durch die Anregung von TEM-Moden ist es möglich, Körper beliebiger Geometrien zu beschichten. Die Beschränkungen auf bestimmte geometrische Verhältnisse wie beim Anregen von TM-Moden entfällt.

Das hierin beschriebene Verfahren und die entsprechende Vorrichtung können nicht nur auf das Beschichten von spritzgeblasenen oder allgemein von blasgeformten Körpern angewendet werden. Vielmehr kann das Verfahren auch für die Beschichtung beliebiger hohlkörperförmiger oder massiver Körper angewendet werden. Dementsprechend ist auch ein Verfahren zum Beschichten eines Körpers vorgesehen, bei welchem
- in einem Beschichtungsreaktor ein Körper ausgebildet oder eingebracht,
- der Körper und/oder der diesen umgebende Raum des Beschichtungsreaktors evakuiert,
- Prozeßgas, beziehungsweise Gase einer Gasatmosphäre und/oder ein Precursor-Gas in den Körper und/oder den umgebenden Beschichtungsreaktor eingeleitet,
- im Inneren des Körpers und/oder im umgebenden Raum des Beschichtungsreaktors gepulste Mikrowellenenergie eingestrahlt, und
- eine Beschichtung auf der Innen- und/oder Außenseite des Körpers abgeschieden wird, wobei durch die gepulste Mikrowellenenergie im Innern des Körpers und/oder dem Beschichtungsreaktor TE-Moden oder TEM-Moden angeregt werden.

Neben der Anregung von TE-Moden oder TEM-Moden sind auch TM_{0xy}-Moden mit x ≥ 2, y ≥ 0 oder eine TM₀₁₀-Mode geeignet, um Körper beliebiger Geometrien ohne Beschränkung auf bestimmte geometrische Verhältnisse beschichten zu können.

Im Falle massiver Körper wird dann selbstverständlich nicht das Innere des Körpers, sondern nur dessen Umgebung im Beschichtungsreaktor evakuiert und die Beschichtung dann auch in diesem Bereich vorgenommen.

Das kontinuierlich brennende Plasma schirmt das äußere elektromagnetische Feld ab. Die magnetischen und elektrischen Feldstärken in der Plasmazone werden durch das Plasma selbst gedämpft. Die Dämpfung des zuvor resonant oszillierenden elektromagnetischen Felds führt im allgemeinen zu einem Zusammenbrechen der Resonanz und einer stark veränderten Feldverteilung. Bei kontinuierlicher Einstrahlung werden daher die Vorteile eines resonant oszillierenden Feldes für die Beschichtung durch die zusammenbrechende Resonanz zunichte gemacht. Erst die erfindungsgemäße gepulste Anregung erlaubt es, in der Beschichtungskammer die Verteilung der Plasmaintensität einer Feldverteilung entsprechend einer resonanten Mode aufrechtzuerhalten. Beim Zünden des Plasmas am Beginn eines Pulses ist die resonante Mode noch vorhanden. Diese wird im Verlauf des Pulses gedämpft. Bei kontinuierlicher Einstrahlung würde sich nun die Plasmaverteilung durch die Dämpfung ändern und eine gleichmäßige Beschichtung verhindern. Gerade dies wird durch das Abschalten der Mikrowellenenergie und erneutes Einschalten zu Beginn des nächsten Pulses jedoch vermieden.

Der Beschichtungsraum des Reaktors kann außerdem vorteilhaft so ausgestaltet werden, daß die Moden während eines gezündeten Plasmas, beziehungsweise während des Beschichtens erhalten bleiben. Dabei wird die Dämpfung des elektromagnetischen Felds durch das Plasma bei der Wahl der Abmessungen des Beschichtungsraum berücksichtigt.
Des weiteren ist bei einer gepulsten Anregung eines Plasmas die Wärmebelastung des zu beschichtenden Kunststoffes reduziert. Darüber hinaus ermöglicht ein gepulstes Verfahren eine genaue Prozeßführung, da mit Hilfe der Zahl der Impulse die Abscheideraten auf dem Kunststoffsubstrat genau gesteuert werden können. Des weiteren ist das Abscheiden komplexerer Systeme, beispielsweise von anorganischen/organischen Wechselschichten oder Gradientenschichten möglich, da in den Impulspausen beispielsweise ein vollständiger Gasaustausch erfolgen kann.

Neben dem Spritzblasen können für das Verfahren auch andere Blasformverfahren, wie beispielsweise das Extrusionsblasen, das Coextrusionsblasen, das Spritz-Streckblasen oder das Tauchblasen eingesetzt werden.

Besonders bevorzugt ist es, wenn die Mikrowellenenergie über Antennen, Schlitze oder dielektrische Fenster eingekoppelt wird, die an den Seitenwänden oder dem Deckel des Reaktors angeordnet ist.

Neben dem Verfahren stellt die Erfindung auch eine Vorrichtung zum Blasformen, insbesondere zum Spritzblasen eines Körpers und zum Beschichten zur Verfügung sowie Körper, die nach einem derartigen Verfahren hergestellt sind.

Die Vorrichtung zum Blasformen, insbesondere zum Spritzblasen und Beschichten eines Körpers, umfasst:
- einen Beschichtungsreaktor mit wenigstens einer Öffnung,
- Zuleitungen in den Beschichtungsreaktor für das Spritzblasgut,
- eine Vorrichtung zum Einblasen von Gas in das Spritzblasgut, so daß ein Hohlkörper ausgebildet wird,
- Zuleitungen zum Evakuieren des Hohlkörpers und/oder des Beschichtungsreaktors,
- Vorrichtungen zum Zuführen von Gasen in das Innere des Hohlkörpers und/oder dem Beschichtungsreaktor und
- eine Einrichtung zum gepulsten Zünden eines Plasmas in dem Hohlkörper und/oder dem Beschichtungsreaktor durch Mikrowellenenergie.

Eine weitereVorrichtung zum Beschichten von Körpern, die insbesondere zur Durchführung des erfindungsgemäßen Verfahrens eingerichtet ist, umfaßt
- einen Beschichtungsreaktor,
- Zuleitungen zum Evakuieren des Hohlkörpers und/oder des Beschichtungsreaktors,
- Vorrichtungen zum Zuführen von Gasen in das Innere des Hohlkörpers und/oder dem Beschichtungsreaktor, sowie eine
- Einrichtung zum gepulsten Zünden eines Plasmas in dem Hohlkörper und/oder dem Beschichtungsreaktor. Dabei ist der Beschichtungsreaktor so ausgebildet, daß durch die gepulste Mikrowellenenergie im Innern des Körpers und/oder dem Beschichtungsreaktor TE-Moden, TEM-Moden, TM_{0xy}-Moden mit x ≥ 2, y ≥ 0 oder eine TM₀₁₀-Mode angeregt werden.

Eine solche Vorrichtung muß auch für das Blasformen, insbesondere für das Spritzblasen der Körper eingerichtet sein.

Formkörper, die mit einer erfindungsgemäßen Vorrichtung hergestellt werden, umfassen bevorzugt eines oder mehrere der nachfolgenden Materialien:
polyzyklische Kohlenwasserstoffe, Polycarbonate, Polyethylenterphthalate, Polystyrol, Polyethylen, insbesondere HDPE, Polypropylen, Polymethylmetacrylat, PES. Dementsprechend umfasst auch das Blasformgut, insbesondere das Spritzblasgut für das Spritzblasen eines solchen Körpers zumindest eines dieser Materialien. Insbesondere ist es möglich, polyzyklische Kohlenwasserstoffe, wie COC, die bereits selbst einen hochdichten Barrierekunststoff darstellen, derart zu beschichten, daß dieser hochdichte Barrierekunststoff vor einem Angriff durch organische Stoffe, insbesondere durch Fette geschützt wird.

In einer bevorzugten Ausführungsform weist die Barrierebeschichtung eine Dicke < 1000 nm, bevorzugt < 300 nm auf. Derartige Barriereschichten weisen neben guten Barriereeigenschaften auch eine hohe Flexibilität auf. Des weiteren können bei derartig dünnen Schichten insbesondere auch intrinsische Spannungen, die zu einem Abplatzen der Barriereschicht führen können, vermieden werden. In einer besonders bevorzugten Ausführungsform hat die Barriereschicht noch weitere zusätzliche Funktionen, beispielsweise optische oder elektrische Funktionen oder Antikratz- oder Antireflexfunktionen.

Durch das Zünden des Plasmas, beispielsweise mittels HF oder Mikrowelle, wird ein Plasma erzeugt, wodurch in den 3D-Formkörper oder dem evakuierten Raum zwischen den Formhälften eingeleitete Precursor-Gase einer Gasatmosphäre reagieren und auf dem 3D-Formkörper eine Beschichtung abgeschieden wird. Transparente Schichten ergeben sich bei Verwendung nachfolgender Precursor-Materialien: HMDSN, HMDSO, PMS, Silan in N₂, TiCl₄ in einer Atmosphäre aus O₂, N₂, N₂+NH₃. Mit derartigen Materialien können TiO₂, SiO₂ sowie SiₓN_{y}-Schichten auf verschiedenen Kunststoffmaterialien abgeschieden werden. Eine TiO₂-Schicht wird beispielsweise bei Verwendung eines TiCl₄-Precursor-Gases in einer O2-Atmosphäre abgeschieden, eine SiO₂-Barriereschicht aus einem HMDSN-Precursor-Gas in O₂-Atmosphäre, eine Si-N-Barriereschicht bei Verwendung eines SiH₄ bzw. TMS-Precursors in N₂+NH₃-Atmosphäre.

Die Erfindung soll nachfolgend anhand der Ausführungsbeispiele und der Figuren näher erläutert werden.

Es zeigen:

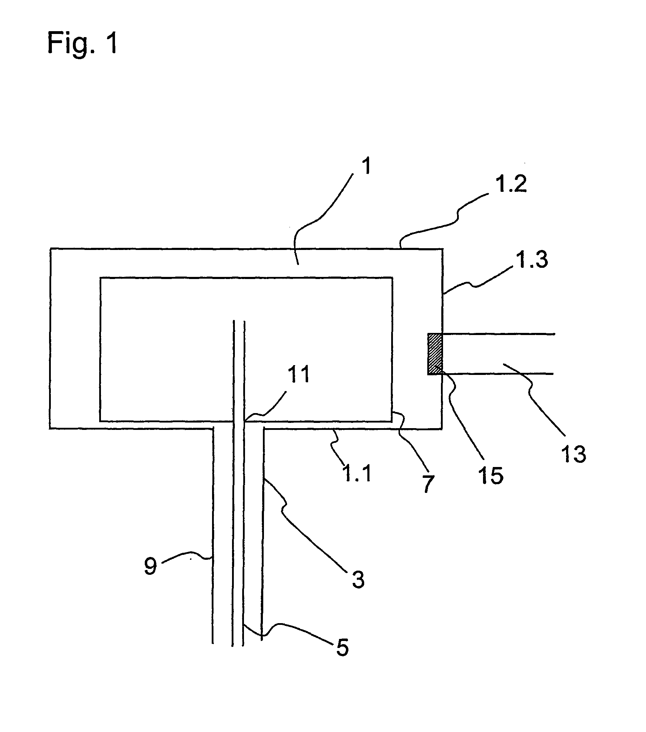

Figur 1: eine erfindungsgemäße Vorrichtung zum Spritzblasen und Beschichten eines Formkörpers.

In Figur 1 ist eine erfindungsgemäße Vorrichtung zum gleichzeitigen Spritzblasen eines Hohlkörpers und Beschichten desselben dargestellt. Die Vorrichtung umfaßt einen Beschichtungsreaktor 1 mit einem Bodenteil 1.1, einem Deckelteil 1.2 sowie Seitenwänden 1.3. Des weiteren ist im Boden des Beschichtungsreaktors eine Öffnung 3 vorgesehen, in die eine Lanze 5, wie in Figur 1 gezeigt, eingeführt werden kann. Durch die Lanze 5 wird der Kunststoff des Formkörpers zusammen mit gasförmigem Medium in das Innere des Beschichtungsreaktors 1 eingebracht. Durch das kontinuierliche Zuführen gasförmige Medien über die Lanze 5 entsteht im Inneren des Hohlkörpers, umfassend das eingespritzte Kunststoffmaterial, ein Überdruck, so daß sich ein geblasener Hohlkörper 7 im Inneren des Beschichtungsreaktors 1 ausbildet. Nachdem der Hohlkörper 7 mit Hilfe von Spritzblasen erzeugt wurde, wird die Lanze 5 aus dem Hohlkörper herausgezogen und über die Zuleitung 9 der Beschichtungsreaktor in das Innere des Hohlkörpers evakuiert. Sodann wird über die Zuleitung 9 das Gas einer Gasatmosphäre und ein Precursor-Gas in das Innere des Beschichtungsreaktors über die durch das Herausziehen der Lanze 5 zurückbleibende Öffnung 11 eingebracht. Sodann wird über eingekoppelte Energie, beispielsweise HF-Energie oder Mikrowellenenergie, im Inneren des Hohlkörpers 7 sowie im Inneren des Reaktors 1 ein Plasma gezündet. In der vorliegenden Ausführungsform wird das Plasma mit Hilfe von über eine Hohlleiterstruktur 13 zugeführter Mikrowellenenergie gezündet. Die über den Hohlleiter 13 zugeführte Mikrowellenenergie wird über ein dielektrisches Fenster 15 an der Seitenwand 1.3 des Reaktors in das Reaktorinnere und das Innere des Hohlkörpers eingekoppelt. Bei der Mikrowellenenergie handelt es sich um gepulste Mikrowellenenergie. Ein Verfahren zum Beschichten eines Substrates mit Hilfe gepulster Mikrowellenenergie ist beispielsweise in der DE 38 30 249 C2 offenbart, deren Offenbarungsgehalt in die vorliegende Anmeldung vollumfänglich mitaufgenommen wird.

Der Vorteil eines gepulsten Plasmas liegt in der wesentlich niedrigeren Wärmebelastung des zu beschichtenden Kunststoffmaterial sowie der Möglichkeit, TEM sowie TE oder TM₀₁₀-Moden stabil anzuregen, wodurch es möglich wird, Hohlkörper beliebiger Abmessungen zu beschichten.
Des weiteren erlaubt die Anregung des Plasmas durch gepulste Mikrowellenstrahlung eine Beschichtung mit Wechselschichten oder Gradientenschichten, wie beispielsweise in der US 5,736,207 offenbart, deren Offenbarungsgehalt in die vorliegende Anmeldung vollumfänglich mitaufgenommen wird.

Die in das Innere des Hohlkörpers bzw. des Reaktors eingeleiteten Precursor-Gase können HMDSN, HMDSO, TMS, Silan in N₂, TiCl₄ umfassen. Als Gasatmosphäre ist eine O₂-Atmosphäre, eine N₂-Atmosphäre oder eine N₂+NH₃-Atmosphäre denkbar. Mit Hilfe des gepulsten Plasmas kann der e Hohlkörper innen und optional außenseitig mit einer Beschichtung wie beispielsweise einer SiOₓ-, einer TiOₓ-sowie einer SnOₓ- oder einer SiₓN_{y}-Beschichtung, bevorzugt mit einer Dicke im Bereich 10 bis 1000 nm, versehen werden. Die auf den Kunststoff-Hohlkörper aufgebrachte Beschichtung kann als Barrierebeschichtung, beispielsweise als Sauerstoff-Barrierebeschichtung, dienen.

Mit der erfindungsgemäßen Vorrichtung bzw. dem erfindungsgemäßen Verfahren, ist es möglich, in ein und derselben Vorrichtung einen Kunststoffkörper durch Spritzblasen herzustellen und zu beschichten. Der Vorteil der erfindungsgemäßen Vorrichtung liegt darin, daß Formkörper beliebiger Geometrie und Abmessung beschichtet werden können.

## Patentansprüche

1. Verfahren zum Blasformen, insbesondere Spritzblasen und Beschichten eines Körpers, umfassend die folgenden Schritte:
- in einem Beschichtungsreaktor (1) mit wenigstens einer Öffnung (3) wird durch diese Öffnung (3) ein Kunststoffmaterial eingebracht und durch Einblasen eines Gases durch diese Öffnung (3) ein Körper (7) ausgebildet,
- der Körper (7) und/oder der diesen umgebende Raum des Beschichtungsreaktor wird evakuiert
- in dem Körper und/oder dem umgebenden Beschichtungsreaktor (1) werden ein Precursor-Gas und Gase einer Gasatmosphäre eingeleitet,
das Verfahren ist **dadurch gekennzeichnet, daß** im Inneren des Körpers (7) und/oder dem umgebenden Raum des Beschichtungsreaktors (1) gepulste Mikrowellenenergie derart eingestrahlt wird, daß eine Beschichtung auf der Innen- und/oder Außenseite des Körpers (7) durch gepulste PICVD (Plasma Impulse Chemical Vapor Deposition) abgeschieden wird.

2. Verfahren zum Beschichten eines Körpers nach Anspruch 1 **dadurch gekennzeichnet, daß**
durch die gepulste Mikrowellenenergie im Innern des Körpers und/oder dem Beschichtungsreaktor TE-Moden oder TEM-Moden angeregt werden.

3. Verfahren zum Beschichten eines Körpers nach Anspruch 1 **dadurch gekennzeichnet, daß**
im Innern des Körpers und/oder des Beschichtungsreaktors TM_{0xy}-Moden mit x ≥ 2, y ≥ 0 oder eine TM₀₁₀-Mode angeregt wird.

4. Verfahren nach Anspruch 2 oder 3, **dadurch gekennzeichnet, daß** die Moden während des Beschichtens erhalten bleiben.

5. Verfahren nach einem der Ansprüche 1 bis 4, **dadurch gekennzeichnet, daß**
die Mikrowellenenergie über Antennen, Schlitze oder dielektrische Fenster eingekoppelt wird.

6. Verfahren nach einem der Ansprüche 1 bis 5, **dadurch gekennzeichnet, daß**
der Reaktor einen Boden, Seitenwände und einen Deckel umfaßt, wobei die Öffnung im Boden des Reaktors ausgebildet wird und die Antennen, Schlitze oder dielektrischen Fenster zum Einkoppeln der Mikrowellenenergie an den Seitenwänden angeordnet sind.

7. Verfahren nach einem der Ansprüche 1 bis 6, **dadurch gekennzeichnet, daß**
der Reaktor einen Deckel, Seitenwände und einen Boden umfaßt, und die Antennen, Schlitze oder die dielektrischen Fenster im Deckel des Reaktors angeordnet sind.

8. Vorrichtung zum Blasformen, insbesondere zum Spritzblasen und Beschichten eines Körpers umfassend:
- einen Beschichtungsreaktor (1) mit wenigstens einer Öffnung (3)
- Zuleitungen in den Beschichtungsreaktor (1) für das Spritzblasgut
- Vorrichtung zum Einblasen von Gas in das Spritzblasgut, so daß ein Hohlkörper ausgebildet wird
- Zuleitungen zum Evakuieren des Hohlkörpers (7) und/oder des Beschichtungsreaktors (1)
- Vorrichtungen zum Zuführen von Gasen in das Innere des Hohlkörpers (7) und/oder dem Beschichtungsreaktor (1)
- Einrichtung zum gepulsten Zünden eines Plasmas in dem Hohlkörper (7) und/oder dem Beschichtungsreaktor (1) durch Mikrowellenenergie.

9. Vorrichtung gemäß Anspruch 8, **dadurch gekennzeichnet, daß**
die Mikrowellenenergie über Antennen, Schlitze oder dielektrische Fenster eingekoppelt wird.

10. Vorrichtung gemäß Anspruch 9, **dadurch gekennzeichnet, daß**
die Antennen, Schlitze oder dielektrischen Fenster an den Seitenwänden oder im Deckel des Beschichtungsreaktors (1) angeordnet sind.

## Claims

1. Method for blow moulding, in particular injection blow moulding, and coating a body, including the following steps:
- in a coating reactor (1) having at least one opening (3), a synthetic material is introduced through this opening (3) and a body (7) is formed by blowing a gas in through this opening (3),
- the body (7) and/or the space of the coating reactor surrounding this body is vented,
- a precursor gas and gases of a gas atmosphere are introduced in the body and/or the surrounding coating reactor (1),
the method is **characterised in that** within the body (7) and/or the surrounding space of the coating reactor (1) pulsed microwave energy is irradiated such that a coating is deposited on the inner and/or outer side of the body (7) by pulsed PICVD (Plasma Impulse Chemical Vapour Deposition).

2. Method for coating a body as claimed in Claim 1, **characterised in that** TE modes or TEM modes are excited by the pulsed microwave energy within the body and/or the coating reactor.

3. Method for coating a body as claimed in Claim 1, **characterised in that** TM_{0xy} modes with x ≥ 2, y ≥ 0 or a TM₀₁₀ mode is excited within the body and/or the coating reactor.

4. Method as claimed in Claim 2 or 3, **characterised in that** the modes are maintained throughout the coating process.

5. Method as claimed in any one of Claims 1 to 4, **characterised in that** the microwave energy is coupled-in via antennas, slots or dielectric windows.

6. Method as claimed in any one of Claims 1 to 5, **characterised in that** the reactor includes a base, side walls and a cover, wherein the opening is formed in the base of the reactor and the antennas, slots or dielectric windows for coupling-in the microwave energy are disposed on the side walls.

7. Method as claimed in any one of Claims 1 to 6, **characterised in that** the reactor includes a cover, side walls and a base, and the antennas, slots or dielectric windows are disposed in the cover of the reactor.

8. Apparatus for blow moulding, in particular for injection blow moulding, and coating a body including:
- a coating reactor (1) having at least one opening (3),
- supply lines into the coating reactor (1) for the material to be injection blow moulded,
- an apparatus for blowing gas into the material to be injection blow moulded so that a hollow body is formed,
- supply lines for venting the hollow body (7) and/or the coating reactor (1),
- apparatuses for supplying gases into the interior of the hollow body (7) and/or the coating reactor (1),
- a device for the pulsed ignition of a plasma in the hollow body (7) and/or the coating reactor (1) by microwave energy.

9. Apparatus as claimed in Claim 8, **characterised in that** the microwave energy is coupled-in via antennas, slots or dielectric windows.

10. Apparatus as claimed in Claim 9, **characterised in that** the antennas, slots or dielectric windows are disposed on the side walls or in the cover of the coating reactor (1).

## Revendications

1. Procédé pour le formage par soufflage, en particulier pour l'injection-soufflage et le revêtement d'un corps, comprenant les étapes suivantes :
- dans un réacteur de revêtement (1) présentant au moins une ouverture (3), un matériau plastique est introduit par cette ouverture (3) et un corps (7) est conçu par insufflation d'un gaz par cette ouverture (3),
- le corps (7) et/ou l'espace environnant ce corps du réacteur de revêtement est mis sous vide,
- un gaz précurseur et des gaz d'une atmosphère gazeuse sont introduits dans le corps et/ou le réacteur de revêtement (1) environnant,
le procédé est **caractérisé en ce que** de l'énergie de micro-ondes pulsée est envoyée à l'intérieur du corps (7) et/ou dans l'espace environnant du réacteur de revêtement (1) de telle sorte qu'un revêtement est précipité sur le côté intérieur et/ou le côté extérieur du corps (7) par PICVD (Plasma Impulse Chemical Vapor Deposition) pulsée.

2. Procédé pour le revêtement d'un corps selon la revendication 1, **caractérisé en ce que**
des modes TE ou des modes TEM sont excités par l'énergie de micro-ondes pulsée à l'intérieur du corps et/ou dans le réacteur de revêtement.

3. Procédé pour le revêtement d'un corps selon la revendication 1, **caractérisé en ce que**
des modes TM_{oxy} avec x ≥ 2, y ≥ 0 ou un mode TM₀₁₀ est/sont excité(s) à l'intérieur du corps et/ou du réacteur de revêtement.

4. Procédé selon la revendication 2 ou 3, **caractérisé en ce que** les modes sont conservés pendant le revêtement.

5. Procédé selon l'une quelconque des revendications 1 à 4, **caractérisé en ce que**
l'énergie de micro-ondes est injectée par des antennes, des fentes ou des fenêtres diélectriques.

6. Procédé selon l'une quelconque des revendications 1 à 5, **caractérisé en ce que**
le réacteur comprend un fond, des parois latérales et un couvercle, l'ouverture étant réalisée dans le fond du réacteur et les antennes, fentes ou fenêtres diélectriques étant disposées sur les parois latérales pour l'injection de l'énergie de micro-ondes.

7. Procédé selon l'une quelconque des revendications 1 à 6, **caractérisé en ce que**
le réacteur comprend un couvercle, des parois latérales et un fond et les antennes, fentes ou les fenêtres diélectriques sont disposées dans le couvercle du réacteur.

8. Dispositif pour le formage par soufflage, en particulier pour l'injection-soufflage et le revêtement d'un corps comprenant :
- un réacteur de revêtement (1) présentant au moins une ouverture (3),
- des arrivées dans le réacteur de revêtement (1) pour le produit moulé par injection-soufflage,
- dispositif pour l'insufflation de gaz dans le produit moulé par injection-soufflage, de sorte qu'un corps creux est formé.
- des arrivées pour la mise sous vide du corps creux (7) et/ou du réacteur de revêtement (1),
- des dispositifs pour l'arrivée de gaz à l'intérieur du corps creux (7) et/ou au réacteur de revêtement (1)
- dispositif pour l'allumage pulsé d'un plasma dans le corps creux (7) et/ou le réacteur de revêtement (1) par de l'énergie de micro-ondes.

9. Dispositif selon la revendication 8, **caractérisé en ce que**
l'énergie de micro-ondes est injectée par des antennes, fentes ou fenêtres diélectriques.

10. Dispositif selon la revendication 9, **caractérisé en ce que**
les antennes, fentes ou fenêtres diélectriques sont disposées sur les parois latérales ou dans le couvercle du réacteur de revêtement (1).
